# EUROPÄISCHE PATENTSCHRIFT

(11) **EP 0 686 303 B1**
(45) Veröffentlichungstag und Bekanntmachung des Hinweises auf die Patenterteilung: **13.12.2000**
(21) Anmeldenummer: 94906982.7
(22) Anmeldetag: 25.02.1994
(51) Int. Cl.: H01L 21/00

(54) **VORRICHTUNG UND VERFAHREN ZUM TRANSPORTIEREN VON FLACHEN GEGENSTÄNDEN, INSBESONDERE VON SUBSTRATEN**
PROCESS AND DEVICE FOR TRANSPORTING FLAT OBJECTS, IN PARTICULAR SUBSTRATES
PROCEDE ET DISPOSITIF DE TRANSPORT D'OBJETS PLATS, NOTAMMENT DE SUBSTRATS

(30) Priorität: 26.02.1993 CH 59893; 27.04.1993 CH 127793
(43) Veröffentlichungstag der Anmeldung: 13.12.1995
(73) Patentinhaber: MAYER, Herbert E., FL-9495 Triesen (LI)
(72) Erfinder: MAYER, Herbert E., FL-9495 Triesen (LI)
(74) Vertreter: Riederer, Conrad A., Dr.
(86) Internationale Anmeldenummer: IB9400024
(87) Internationale Veröffentlichungsnummer: WO9419821

(56) Entgegenhaltungen:
- EP-A- 0 445 651
- WO-A-92/05920
- US-A- 5 044 752
- US-A- 5 163 312

## Beschreibung

Die vorliegende Erfindung betrifft eine Vorrichtung und ein Verfahren zum Transportieren von flachen Gegenständen, insbesondere von Substraten, z.B. Wafern, aus einer eine Vielzahl von Ladeflächen aufweisenden Kassette in eine andere Kassette oder aus einer Kassette in eine Bearbeitungsstation oder dergleichen, mit einem beweglichen Greifer, welcher einen Tragarm und Mittel zum Malten des flachen Gegenstandes aufweist.

Wafer als Ausgangsmaterial bei der Herstellung von Mikrochips müssen während des Herstellprozesses öfters umgeladen werden, z.B. von einer Waferkassette zu einer anderen oder von einer Waferkassette in eine Bearbeitungsstation oder dergleichen. Diese Manipulationen finden unter Reinraumbedingungen unter Zuhilfenahme von Robotern oder Transportvorrichtungen statt. Die Oberflächen der Wafer sind sehr empfindlich und können bereits durch kleinste Partikel kontaminiert werden, wodurch die Ausschussproduktion zunimmt. Neben der Aufrechterhaltung einer entsprechenden partikelfreien Atmosphäre während den Transportoperationen ist von besonderer Bedeutung, dass die Kontaktflächen zwischen Wafern und Haltemitteln möglichst klein gehalten werden, weil beim Berühren gerne Partikel übertragen werden. Auch werden bereits Partikel erzeugt, wenn zwei Oberflächen aneinander reiben.

US-4,900,314 zeigt eine Vorrichtung zum Transportieren von Wafern mit einem Rahmen und einem länglichen Arm, welcher in ein Fach einer Waferkassette eingreifen kann. Der Arm weist am äusseren Ende einen ersten herabhängenden Haken auf, welcher einen Teil des Wafer-Randes fassen kann. Die Stärke des ersten Hakens und des Arms zusammen genommen müssen dabei kleiner als der lichte Abstand zweier Wafer in einer Standardkassette sein, damit beim Eingreifen in ein Fach einer Kassette kein Wafer berührt wird. Am zum Rahmen näheren Ende des Arms befindet sich ein zweiter Haken, welcher von oben her durch einen länglichen Schlitz im Arm ragt und zum Fassen eines Wafers pneumatisch entgegen einer Federkraft in Längsrichtung verschoben werden kann. Nachteilig bei dieser Anordnung ist, dass der in die Kassette einfahrende Arm die in der Kassette liegenden Wafer bei der Hol- resp. Bringbewegung touchieren kann, weil die Position des zu greifenden Wafers nicht erfasst wird. So ist die dem Arm, z.B. in einer Kassette für 6 Zoll Wafer, zur Verfügung stehende Distanz zwischen zwei übereinanderliegenden Wafern aufgrund der Toleranzen der Abmessungen der Kassetten resp. der Kassettenfächer lediglich ca. 3.5 mm. Dazu kommen zusätzliche Differenzen in den Abmessungen, wenn man Kassetten unterschiedlicher Hersteller nebeneinander verwendet.

Wird hingegen der Arm schwächer konstruiert, so besteht die Gefahr, dass sich der Arm aufgrund des Gewichtes des Wafers durchbiegt oder beim Wafer-Transport zu schwingen anfängt. Dies dürfte besonders im Fall der grossen Wafer zutreffen. Ein weiterer Nachteil der Vorrichtung gemäss US-4,900,314 besteht darin, dass zum Fassen des Wafers der zweite Haken entgegen einer Federkraft verschoben wird, sodass bei einem allfälligen Druckluft- oder Stromausfall der Wafer herunterfallt.

Die EP-A-0 445 651 zeigt eine Vorrichtung zum Halten und Transportieren von flachen Substraten, insbesondere Wafern, mit einem beweglichen Arm, welcher mit einem Greifer versehen ist, an welchem ein zu haltender bzw. zu transportierender Wafer über wenigestens zwei in der Ebene der Waferscheibe sich gegenüberliegende Tragelemente befestigbar ist. Eines der Tragelemente ist dabei ortsfest angeordnet, und das andere ist verschiebbar ausgebildet. Zum Festklemmen des Wafers kann das verschiebbare Tragelement mittels einer Drehfuhrung um 90 Grad von der Ruhelage in die Arbeitslage gedreht werden. Bei dieser Ausführungsform ist nachteilig, dass die den Klemmpin haltende Drehfuhrung im entfernteren Ende des Greifer gelagert wird und beim Betätigen, also beim Drehen resp. Ziehen und Stossen, durch die unvermeidbare Reibung in der Lagerung Partikel entstehen, die auf den Wafer fallen können.

Um zu vermeiden, dass der Greifer beim Einfahren in die Wafer-Kassette einen benachbarten Wafer touchiert, wäre es vorteilhaft, wenn der Greifer an die richtige Position manövriert werden könnte, indem die Position des Wafers zuerst gemessen würde. Dies könnte, so würde man meinen, z.B. durch ein optisches Detektionssystem geschehen, indem ein Lichtstrahl an der vorderen Waferkante reflektiert würde. Dieses Vorhaben wird aber in der Praxis bereits durch den bei vielen Wafern vorhandenen Flat verhindert, dessen Orientierung bei der Chip-Herstellung in der Regel nicht kontrolliert wird. Durch die Transportoperationen und während des Bearbeitungsprozesses kann sich die Orientierung des Flat also ändern. Ist die Lage der geraden Waferflatkante bezüglich des optischen Detektionssystems aber nicht definiert, sondern ist diese zufällig orientiert, so können die reflektierten Lichtstrahlen in einem grossen Bereich streuen und treffen dabei u.U. nicht mehr auf den Detektor. Ein weiteres Problem ist, dass die Abstände zweier in einer Standardkassette über- oder nebeneinander liegender Wafer sehr gering sind, sodass ein optisches Detektionssystem z.B. nicht vorne am Greifer angeordnet sein kann. Befindet sich das Detektionssystem in einem Abstand zu den Wafern, so ist aber möglicherweise die Intensität des reflektierten Lichts zu gering. Diese Problematik wird dadurch noch verschärft, dass die Waferkanten häufig gerundet sind, sodass das auf den Wafer auftreffende Licht noch weiter gestreut und diffuser wird. Des weiteren werden die Wafer heutzutage oft mit einer Kerbe versehen, deren Innenflächen zur Markierung der Wafer verwendet werden. Trifft ein Lichtstrahl auf diese Kerbe, so wird er in einer ganz anderen, unerwarteten Richtung reflektiert.

Die schon genannte EP-A-0 445 651 umgeht die oben erwähnten Probleme, indem der von einem Sender ausgesandte Lichtstrahl durch einen hinter der Waferkassette aufgestellten Spiegel reflektiert wird. Der Sender und der Empfänger der EP-A-0 445 651 sind auf dem beweglichen Teil eines Arms im gleichen Abstand von der Längsachse des Arms einander gegenüberliegend angeordnet. Der Sender sendet den Lichtstrahl in einem bestimmten Winkel zur Längsachse des Arms aus. Dieser wird dann durch den Spiegel zurück auf den Empfänger reflektiert. Befindet sich ein Wafer in der Kassette, so wird der Lichtstrahl unterbrochen. Diese optische Detektionseinrichtung hat den Nachteil, dass sie lediglich das Vorhandensein eines Wafers erfasst aber seine Position nicht exakt bestimmen kann. Auch muss bei dieser Anordnung hinter der Wafer-Kassette in einem bestimmten Abstand zur Detektionseinrichtung ein Spiegel so angeordnet sein, dass der einfallende Lichtstrahl auf den Empfänger reflektiert wird. Dabei trifft der reflektierte Lichtstrahl nur dann auf den Empfänger, wenn der Sender und Empfänger in einem bestimmten Abstand vom Spiegel sind. Für das direkte Erfassen eines Wafers ohne die Verwendung eines Spiegels eignet sich diese Einrichtung wegen der möglichen, zufälligen Orientierung des schon erwähnten Waferflat nicht. Wäre der Flat z.B. seitlich orientiert, so träfe der reflektierte Lichtstrahl nicht auf den Empfänger. Ein weiteres Problem ist, dass in der Praxis die Wafer nie gleich tief in der Waferkassette liegen, sodass der Abstand vom Sender zum Wafer nicht konstant ist. Dies verhindert ebenfalls eine zuverlässige Positionsbestimmung mit der erwähnten Vorrichtung. Ausserdem kann das oben beschriebene optische Detektionssystem nicht sicherstellen, dass der in eine Waferkassette eingreifende Arm nicht einen der zum Arm benachbarten Wafer bei der Holbewegung touchiert. Beim Touchieren werden Partikel erzeugt, welche auf den Wafer fallen und die mikroelektronischen Bauteile zerstören können.

Die WO-A-92/05920 offenbart eine Transportvorrichtung mit einem Roboterarm, welcher entlang der r-, o- und z-Achsen verschiebbar ist. Der Roboterarm besitzt einen Tragarm, welcher in die Zwischenräume der in einer Waferkassette gestapelten Wafer eingeführt werden kann und welcher Oeffnungen besitzt, um einen Wafer mittels Vakum am Tragarm zu halten. Die WO-A-92/05920 offenbart weiters eine optische Detektionseinrichtung, die gemäss einem bevorzugten Ausführungsbeispiel zwei Lichtquellen und zwei Empfänger besitzt. Die erste Lichtquelle sendet einen ersten Lichtstrahl longitudinal und parallel zu den gestapelten Wafern aus, um mittels eines ersten Empfängers die An- oder Abwesenheit eines Wafers vor dem Tragarm festzustellen. Die zweite Lichtquelle sendet einen zweiten Lichtstrahl in einem Winkel zwischen 0 und 90 Grad aus, um mittels eines zweiten Empfängers überhängende Wafer festzustellen.

Die US 5,044,752 offenbart eine Transportvorrichtung mit Haltemitteln und auf den Haltemitteln angeordneten Detektionsmitteln bestehend aus wenigstens zwei in Abstand von einander angeordneten Sensoren. Die Sensoren erzeugen je ein elektrisches Signal, dessen Grösse von der Bedeckung durch den jeweiligen Wafer abhängig ist. Aus der prozentualen Bedeckung der Sensoren kann dann durch einen Mikroprozessor die relative Lage das Wafers auf den Haltemitteln ermittelt werden.

Es ist Aufgabe der vorliegenden Erfindung, ein Verfahren und eine Vorrichtung zum Transportieren eines flachen Gegenstandes, insbesonders eines Wafers, zur Verfügung zu stellen, durch welche die eingangs erwähnten Nachteile mindestens teilweise vermieden werden können. Die Transportvorrichtung soll einen Wafer in einer beliebigen Orientierung und in einem beliebigen Fach einer Kassette entnehmen resp. deponieren können, ohne mit benachbarten Wafern zu kollidieren und Partikel zu erzeugen. Insbesondere soll die Gefahr der Kontamination der Wafer durch vom Greifer herrührende resp. durch die Transportbewegung verursachte Partikel auf ein Minimum reduziert werden.

Erfindungsgemäss geschieht dies dadurch, dass am Tragarm wenigstens ein Distanzsensor vorgesehen ist, welcher während einer Holbewegung die Distanz zu wenigstens einem zum Tragarm benachbarten flachen Gegenstand misst. Im Unterschied zu den bekannten Lösungen haben eigene Untersuchungen gezeigt, dass eine vorgängige Positionsbestimmung eines Wafers in der Regel nicht ausreicht, um sicher zu sein, dass durch den Transport keine Partikel erzeugt werden. Der Grund ist die oftmals schiefe Lage der Wafer in der Kassette, die bedingt sein können einerseits durch den schon beschriebenen Waferflat und andererseits durch die seitlichen, von vorne gesehen, sägezahnförmigen Waferauflagen, die z.T. beachtliche Abweichungen von der nominellen Positionen aufweisen können.

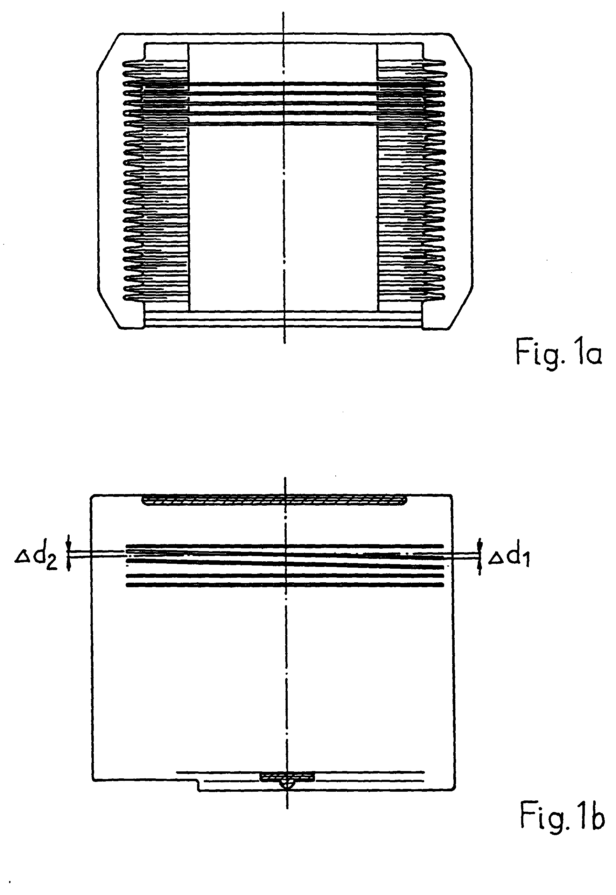

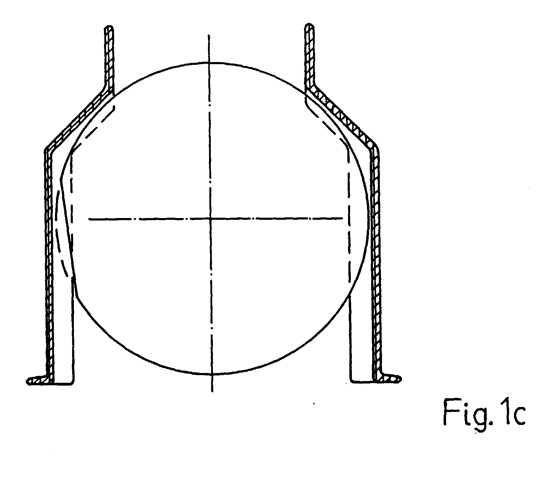

In Fig.1 a bis c ist eine Waferkassette mit darin befindlichen Wafern gezeigt. Ist der Waferflat nämlich wie in Fig.1c dargestellt seitlich orientiert, so neigt sich der Wafer zwangsweise vorne nach unten, weil die seitlichen Auflageflächen nicht horizontal verlaufen und führt zu den Abweichungen Δd₁ und Δd₂ von den Nominalpositionen (Fig.1b). Dazu kommt, dass die Waferauflagen der Kassetten ebenfalls gewisse Toleranzen aufweisen und leicht ansteigend oder abfallend sein können. Soll ein derart schräg liegender Wafer mittels eines Greifers aus der Kassette geholt werden, so touchiert der Greifer mit grosser Wahrscheinlichkeit den zu holenden oder den zu diesem benachbarten Wafer.

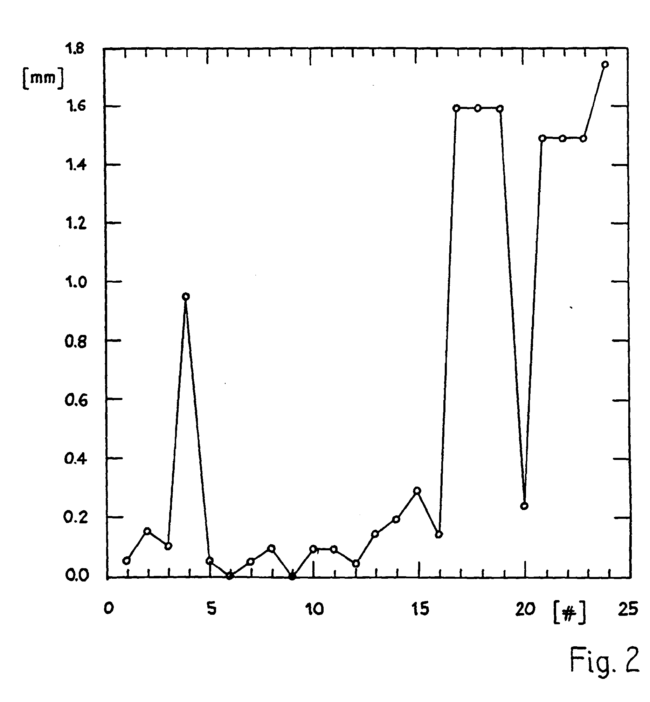

Um die ganze Problematik zu verdeutlichen, wurden die Neigungen von 6 Zoll Wafern in einer Kassette gemessen. Die Ergebnisse sind in der Fig.2 dargestellt. Auf der x-Achse sind die einzelnen Wafer 1 bis 25 aufgetragen, auf der y-Achse sind die Neigungen der gemessenen Wafer ersichtlich. Es ist dabei zu beachten, dass die ersten 16 Wafer zufällig orientiert sind, während bei den letzten 9 Wafern der Waferflat absichtlich seitlich orientiert wurde, sodass dieser auf der Auflage aufliegt. Die Messungen zeigen, dass die Abweichungen von den parallelen Positionen sehr gross sind, nämlich bis zu etwa 1.8 mm, wenn der Waferflat auf einer der beiden Auflagen aufliegt. Dazu kommen natürlich die bereits erwähnten Toleranzen in den Dimensionen der Kassetten. So wurde z.B. festgestellt, dass in der Praxis die untersten Waferauflagen der Kassetten besonders grosse Toleranzen aufweisen. Diese sind vermutlich durch das Schrumpfen des verwendeten Kunststoffs bedingt. Vergleicht man die gemessenen Abweichungen mit dem nominellen, lichten Abstand zweier benachbarter 6 Zoll Wafer in einer Standardkassette, welcher 4.09 mm beträgt, so sieht man, dass eine Kollision des Greifers mit einem benachbarten Wafer möglich ist, auch wenn die Waferpositionen vorgängig gemessen wurden. Denn die Kollision des Greifers mit dem Wafer findet im Fall von benachbarten Wafern, die z.B. mit gegenläufigen Neigungen in der Kassette liegen, nicht an der vorderen Waferkante statt, sondern mit der Waferoberfläche beim Eingreifen in ein Ladefach der Kassette.

Um sicher zu sein, dass keine Partikel durch den Wafer-Transport erzeugt werden, ist es also unumgänglich, dass nicht nur die Wafer-Positionen ermittelt werden, sondern dass auch der Abstand des Tragarms zu wenigstens einem Wafer während des Eingreifens in die Wafer-kassette mit einem Sensor berührungsfrei und vorzugsweise kontinuierlich gemessen wird.

Vorteilhaft ist der Sensor ein von einem Gas durchströmter Fluidsensor. Ein Sensor dieser Art, welcher mit Ueberdruck arbeitet, ist in der EP-A-0 380 967 offenbart. Dieser erlaubt die Messung des Abstandes eines Sensorkopfes von einer zu fühlenden Oberfläche. Der Sensor besteht im wesentlichen aus zwei von einem Medium, z.B.Luft, durchströmbaren Kanälen, welche durch einen weiteren, ein Durchflussmessgerät aufweisenden Verbindungskanal miteinander verbunden sind. Die beiden Kanäle, nämlich ein Kanal und ein Referenzkanal können durch eine Ueberdruckquelle gleichermassen mit Druck beaufschlagt werden, sodass in beiden Kanälen eine laminare Strömung erzeugt wird. Die austretenden Gasstrahlen können senkrecht jeweils auf eine im Abstand von den Austrittsöffnungen der Kanäle angeordnete Oberfläche auftreffen. Ist der Abstand der beiden Oberflächen zu den Austrittsöffnungen unterschiedlich, so wird ein Gasfluss im Verbindungskanal induziert, welcher durch das Durchflussmessgerät erfasst werden kann. Dieser Sensor zeichnet sich durch eine kurze Ansprechzeit aus. Ein Nachteil dieses Sensors ist, dass Luft auf die zu messende Oberfläche geblasen wird und dass dabei Partikel auf die Waferoberflächen gelangen können.

Es ist denkbar, anstelle eines Fluidsensors wenigstens einen optischen Sensor am Tragarm anzuordnen. Durch ein im Tragarm in einem bestimmten Winkel eingelassenes Glasfaserkabel kann ein Lichtstrahl auf einen zum Tragarm benachbarten Wafer gerichtet werden, wobei das reflektierte Licht von einer positionsempfindlichen Diode registriert wird. Nachteilig bei einer solchen Anordnung ist allerdings, dass das Sensorlicht mit Photolack beschichtete Wafer beschädigen kann.

Vorteilhaft wird ein Fluidsensor, welcher mit einem Unterdruck arbeitet, verwendet. Zweckmässigerweise weist dieser Fluidsensor wenigstens zwei in Abstand voneinander angeordnete Oeffnungen auf, wobei die erste Oeffnung an einen ersten Kanal angeschlossen ist, der mit einer Unterdruckquelle in Verbindung steht, und die zweite Oeffnung mit einem zweiten Kanal in Verbindung steht, der einen Einlass für ein gasförmiges Fluidum aufweist und mit einem Durchfluss- oder Druckmessgerät in Verbindung steht, welches eine Strömung oder eine Druckänderung im Kanal messen kann. Befindet sich kein Objekt in der Nähe des Sensorkopfes, so wird Gas aus dem den Sensorkopf umgebenden Raum angesaugt. Nähert sich eine zu fühlende Oberfläche dem Sensorkopf, so erhöht sich durch die Querschnittsverringerung die Strömungsgeschwindigkeit des Gases. Die erhöhte Strömungsgeschwindigkeit erzeugt einen Unterdruck vor der zweiten Oeffnung, sodass Gas auch aus dem zweiten Kanal angesaugt wird und das Durchfluss- oder Druckmessgerät anspricht.

Der erwähnte Fluidsensor weist den Vorteil auf, dass die im Reinraum vorhandene, normalerweise äusserst saubere Atmosphäre angesaugt wird und kein Gas oder Luft aus einer Gasflasche, welche Partikel oder andere Verunreinigungen, wie z.B. Sauerstoff, Kohlenwasserstoffe etc., enthalten kann, auf die empfindlichen Oberflächen geblasen wird, wie dies bei bekannten Sensoren der Fall ist. Es können nämlich sehr leicht, z.B. durch einen nicht geeigneten Druckminderer an der Gasflasche, Partikel erzeugt und im Gasstrom mittransportiert werden. Dabei können auch in der Zuleitung integrierte Partikelfilter Partikel unterhalb einer bestimmten Grösse nicht mehr zuverlassig herausfiltern. Auch ist vielen Fachleuten in der Halbleiterindustrie bekannt, dass die Konditionierung der Gasflaschen resp. deren Vorgeschichte besonders wichtig ist. Wurde die Gasflasche z.B. während ihres Lebens einmal unsachgemäss entleert und offen stehen gelassen, so sättigt sie sich mit Wasserdampf, welcher dann später wieder sukzessive abgegeben wird.

Der mit Unterdruck arbeitende Fluidsensor hat gegenüber dem Stand der Technik auch den Vorteil, dass in der Reinraumatmosphäre unter Umständen noch vorhandene kleine Partikel nicht auf die empfindlichen Oberflächen aufgebracht werden können, weil durch die hohe Strömungsgeschwindigkeit des Gases zwischen dem Sensorkopf und der zu fühlenden Oberfläche die Partikel in den ersten Kanal mit der Unterdruckquelle gesogen werden.

Im Gegensatz zum Stand der Technik können sich auch keine Probleme wegen des unter Umständen unterschiedlichen Luftfeuchtigkeitsgehaltes und/oder der unterschiedlichen Temperatur der Reinraumatmosphäre und des Gases aus einer Druckflasche ergeben. Der beschriebene Sensor weist ausserdem eine sehr kurze Ansprechzeit auf, denn die Signale pflanzen sich mit Schallgeschwindigkeit fort.

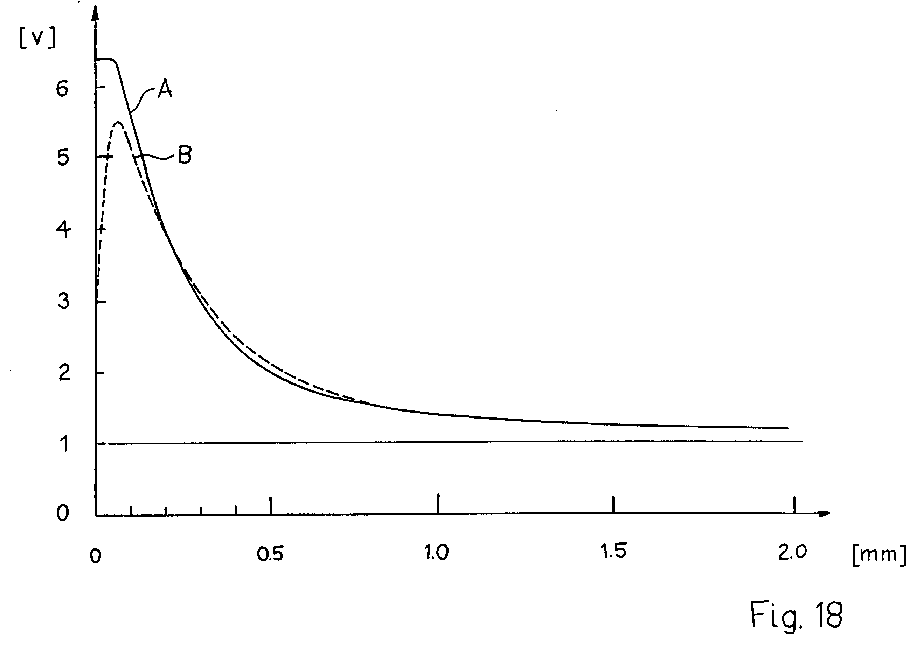

Vorteilhaft sind die Oeffnungen der Kanäle durch eine Rinne miteinander verbunden. Dadurch kann eine unzweideutige Kennlinie des Fluidsensors im sehr nahen Abstandsbereich erreicht werden (Fig.18). Damit wird vermieden, dass die Gasströmung im Kanal mit dem Durchfluss- oder Druckmessgerät bei sehr kleinen Abständen des Sensorkopfes von der zu fühlenden Oberfläche abbricht. Dadurch liefert der Sensor über den ganzen Messbereich eindeutige Messresultate.

Vorteilhaft stehen zwei einander gegenüberliegende erste Oeffnungen mit einem ersten Kanal in Verbindung, und die zweiten Oeffnungen der zweiten Kanäle sind jeweils in Abstand zu einer ersten Oeffnung angeordnet. Mit einem derart ausgebildeten Sensor lassen sich gleichzeitig die Abstände des Tragarms zu zwei zum Tragarm benachbarten Wafern berührungsfrei feststellen. Dies ist zweckmässig, wenn z.B. die grossen 6 Zoll Wafer aus einer entsprechenden Standardkassette geholt werden sollen, weil dort der Spielraum für den Tragarm besonders klein ist. Zweckmässigerweise ist der Fluidsensor im Tragarm integriert. Dies ist eine Anordnung, die sehr platzsparend ist.

Es ist zweckmässig, ein optisches Detektionssystem mit einem Sender und einem Empfänger zur Feststellung der Lage des zu holenden Gegenstandes vorzusehen. Dies erlaubt ein berührungsfreies Eingreifen des Greifers in die Kassette. Vorteilhaft sind die vom Sender ausgesandten Lichtstrahlen ungefähr rechtwinklig auf die Waferkante gerichtet, und der Empfänger erstreckt sich auf wenigstens zwei Seiten des Lichtstrahls, sodass dieser in einem Winkel reflektiertes Licht detektieren kann. Durch diese Anordnung können die Positionen von Wafern unabhängig von der Orientierung des Waferflat oder der Waferkerbe festgestellt werden, weil die z.B. in einem Winkel zum auftreffenden Licht reflektierten Lichtstrahlen durch den Empfänger ebenfalls noch detektiert werden können. Der Sender kann z.B. unterhalb des Greifers, z.B. im Support desselben, oder auf dem Greifer angeordnet sein. Im ersten Fall kann sich ein Empfänger z.B. hinter einem länglichen Schlitz an der Vorderkante des Arms befinden. Im zweiten Fall, wenn also der Sender auf dem Greifer angeordnet ist, kann der Lichtstrahl z.B. mittels Umlenkspiegel so umgelenkt werden, dass die ausgesandten Lichtstrahlen in einem geringen Abstand zur Oberfläche des Greifers auf die Vorderkante eines Wafers fokussiert werden und der Empfänger z.B. an der Vorderkante des Tragarms oder unterhalb davon angeordnet ist. Zweckmässigerweise weist die optische Detektionseinrichtung eine Laserlichtquelle, eine Fokussieroptik, gegebenenfalls Umlenkspiegel oder -Prismen und ein Photoelement auf.

Die Detektionseinrichtung ist vorteilhaft im oder auf dem Support des Greifers angeordnet, und der ausgesandte Lichtstrahl wird durch eine Sammellinse ungefähr punktförmig gebündelt. Die Brennweite der Sammellinse kann zwischen 10 und 50 cm, vorzugsweise zwischen 15 und 35 cm liegen. Bei einer Brennweite von beispielsweise 30cm ergibt sich ein sehr flacher, intensiver Lichtstrahl, sodass die Waferpositionen sehr genau bestimmt werden können. Durch die sehr hohe Lichtintensität an der Substratkante wird auch im Fall eines Glassubstrats genügend Licht reflektiert, um dasselbe detektieren und gleichzeitig dessen Position messen zu können.

Der Empfänger ist in der Arbeitslage zweckmässigerweise in einem Abstand < 20 mm zur zu detektierenden Waferkante positioniert, z.B. unterhalb des Greifers. Nur durch eine Anordnung des Empfängers in einem geringen Abstand zur Waferkante kann genügend Intensität auf den Empfänger fallen, um eine zuverlässige Positionsbestimmung der Waferkante machen zu können, denn der auf die meist abgerundete Waferkante fallende Lichtstrahl wird diffus gestreut, und die Intensität des reflektierten Lichtstrahls nimmt mit dem Quadrat des Abstandes des Empfängers von der Waferkante ab. In einer besonders vorteilhaften Ausführungsform ist der Sender der Detektionseinrichtung am Greifer und der Empfänger am äusseren Ende des Tragarms angeordnet. Dies hat den Vorteil, dass der Abstand zwischen dem Greifer und der Kassette variieren kann, da der Greifer so nahe an die Kassette fahren kann, dass die Intensität des reflektierten Lichts vom Empfänger gemessen werden kann. Weiter ist es vorteilhaft, dass der vom Sender ausgesandte Lichtstrahl zu einem breiten und flachen Strahl fokussiert ist. Dadurch wird unabhängig von der Orientierung des Waferflat oder der Waferkerbe immer genügend Licht für eine exakte Positionsbestimmung des Wafers reflektiert.

Vorteilhaft weist der Greifer einen entlang seiner Längsachse verschiebbaren Tragarm , Mittel zum Verschieben des Tragarms, mindestens ein erstes, ortsfestes Tragelement sowie ein zweites, am Tragarm schwenkbar angeordnetes Tragelement und Mittel zum Schwenken des Tragelements auf. Zweckmässigerweise ist das zweite Tragelement mittels einer ersten Blattfeder am Tragarm und mittels einer zweiten Blattfeder an der bezüglich des Tragarms verschiebbaren Zugstange schwenkbar befestigt. Dadurch kann das Tragelement am Tragarm in die Arbeitslage geschwenkt werden, ohne dass Oberflächen, z.B. in einer Drehführung, aneinander reiben und so Partikel gebildet werden. Dies ist eine besonders einfache und kostengünstige Konstruktion.

Der Tragarm ist in einer vorteilhaften Ausführungsform gehäuseseitig an einer Platte befestigt, die ihrerseits fest mit zwei entlang einer Führungsschiene bewegbaren Schlitten verbunden ist. Die Schlitten können durch Beaufschlagen eines Druck- oder Vakuumzylinders oder durch einen elektronisch steuerbaren Motor entgegen der Kraft einer Zugfeder von der Arbeitslage in die Ruhelage bewegt werden. Durch diese Bauweise kann verhindert werden, dass z.B. bei einem Druckluft-, Vakuum- oder Stromausfall ein Wafer herunterfällt, da der Zylinder gegen die Federkraft wirkt. Besonders vorteilhaft ist die Verwendung eines Vakuumzylinders, weil bei einem Vakuumunterbruch keine Luft ausströmt wie beim Ausfall der Druckluft bei einem Druckzylinder. Denn die Druckluft enthält oft Partikel, die z.B. durch Abrieb gebildet wurden.

Bei der beschriebenen Bauweise kann durch eine entsprechende Lagerung der Schlitten zudem eine praktisch spielfreie Führung des Tragarms erreicht werden. Zweckmässigerweise wirkt ein mit dem Tragarm verbundener Stift derart mit einem Schalter zusammen, dass derselbe beim Zurückziehen des unter Federspannung stehenden Tragarms betätigt wird, wenn die Tragelemente keinen Gegenstand im Eingriff halten. Somit kann festgestellt werden, ob ein Wafer in Eingriff der Tragelemente ist oder nicht.

Vorteilhaft verbindet ein an der Platte schwenkbar angeordneter Winkelhebel die Zugstange mit einer ortsfesten Kulisse gelenkig. Der Winkelhebel ist dabei in einem eine Stufe aufweisenden Schlitz der Kulisse derart geführt, dass beim Verschieben der Platte die Zugstange relativ zum Tragarm bewegt und somit das Tragelement geschwenkt wird. Wenn also das im Schlitz geführte Ende des Winkelhebels über die erwähnte Stufe fährt, wird die Zugstange relativ zum Tragarm verschoben. Dieser Kulissenantrieb erlaubt eine präzise Auslenkung des Tragelements.

Vorteilhaft erstreckt sich die Zugstange von der Blattfeder zum Winkelhebel in einer Nut des Tragarms, wobei die Zugstange den Tragarm nicht berührt. Dadurch kann die Bildung von Partikeln durch Berühren resp. Reiben zweier Oberflächen verhindert werden.

Zweckmässigerweise ist das zweite Tragelement in der Ruhelage etwa bündig mit der Oberfläche des Tragarms, überragt aber in der Arbeitslage den Tragarm um mindestens die Stärke eines Wafers. Durch diese platzsparende Bauweise kann der Tragarm etwas stärker ausgebildet werden, sodass sich dieser unter dem Gewicht des Wafers nicht durchbiegt oder bei der Transportbewegung ins Schwingen gerät. Zweckmässigerweise ist das Tragelement winkelförmig ausgebildet, sodass ein Herunterfallen des Wafers praktisch ausgeschlossen ist. Weiter ist von Bedeutung, dass der Wafer lediglich an der Kante angefasst wird, sodass das Risiko einer Kontamination sehr gering ist. Es ist denkbar, dem vorne am Tragarm angeordneten Tragelement eine andere Form zu geben, denn es ist denkbar, die Wafer auf dem Tragarm zu transportieren. Eine solche Anordnung hat den Vorteil, dass keine Partikel auf die Wafer herrührend von der Transportvorrichtung fallen können, wenn die Wafer einer Kassette jeweils beginnend mit dem untersten transportiert werden.

Im folgenden soll nun Ausführungsformen der Erfindung unter Bezugnahme auf die Figuren beschrieben werden. Es zeigt:
- Fig.1: a) Vorderansicht einer Waferkassette mit Wafern
b) Seitenansicht der Waferkassette
c) Draufsicht auf einen Wafer mit seitlich orientiertem Waferflat
- Fig.2: Gemessene Abweichungen von den parallelen Waferpositionen bei Wafern mit zufälliger Orientierung des Waferflat und Wafern mit seitlicher Orientierung des Waferflat
- Fig.3: eine Seitenansicht einer Transportvorrichtung,
- Fig.4: eine Draufsicht auf die Transportvorrichtung,
- Fig.5: eine Seitenansicht einer optischen Detektionseinrichtung einer ersten Ausführungsart mit punktförmig fokussiertem Lichtstrahl,
- Fig.6: eine Draufsicht auf die optische Detektionseinrichtung von Fig.5,
- Fig.7: eine Seitenansicht eines Greifers einer ersten Ausführungsart,
- Fig.8: eine Draufsicht auf den Greifer von Fig.7,
- Fig.9: a bis c: Ablauf des Greifens eines Wafers
- Fig.10: eine schematische Draufsicht auf eine optische Detektionseinrichtung einer zweiten Ausführungsart mit einem breiten, flach fokussierten Lichtstrahl, welcher
a) auf einen Wafer fällt, bei welchem eine zur Kennzeichnung der Wafers vorgesehene Kerbe in der Längsachse des auftreffenden Lichtstrahls liegt,
b) auf einen Wafer mit seitlich orientiertem Waferflat fällt,
- Fig.11: eine Seitenansicht der Einrichtung von Fig.10,
- Fig.12: eine Seitenansicht eines Greifers einer zweiten Ausführungsart mit der Detektionseinrichtung der Figuren 10 und 11,
- Fig.13: eine Draufsicht auf den Greifer von Fig.12,
- Fig.14: ein Prinzipschema eines mit Unterdruck arbeitenden Fluidsensors,
- Fig.15: Längsschnitt durch einen Tragarm mit einem integriertem Fluidsensor,
- Fig.16: Querschnitt durch den Tragarm mit dem integriertem Fluidsensor
- Fig.17: Querschnitt wie Fig. 16, jedoch durch einen Tragarm mit einem integrierten Doppel-Fluidsensor,
- Fig.18: Kennlinien verschiedener Ausführungsformen des Fluidsensors.

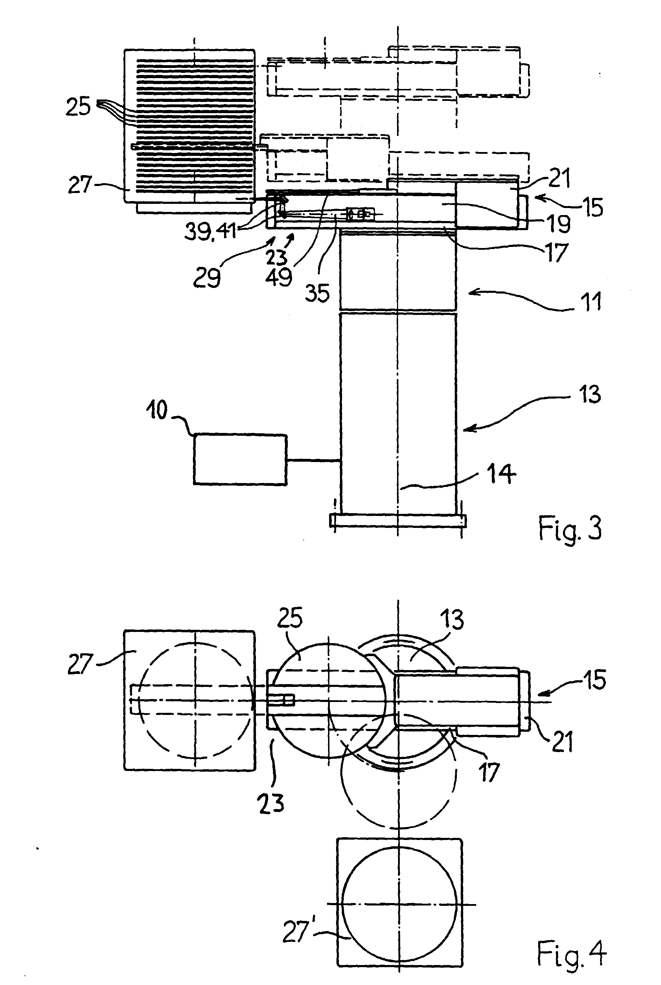

Die in den Figuren 3 und 4 dargestellte Transportvorrichtung 11 umfasst eine Teleskopsäule 13 zur Höhenverstellung und einen Arm 15, welcher um die Längsachse 14 der Säule 13 frei drehbar ist. Der Arm 15 weist einen Support 17 und eine am Support 17 befestigte Linearführung 19 mit einem Schlitten 21 auf, an welchem ein Greifer 23 befestigt ist. Bei der Transportvorrichtung 11 befindet sich eine Waferkassette 27 mit darin befindlichen Wafern 25 (Fig.3).

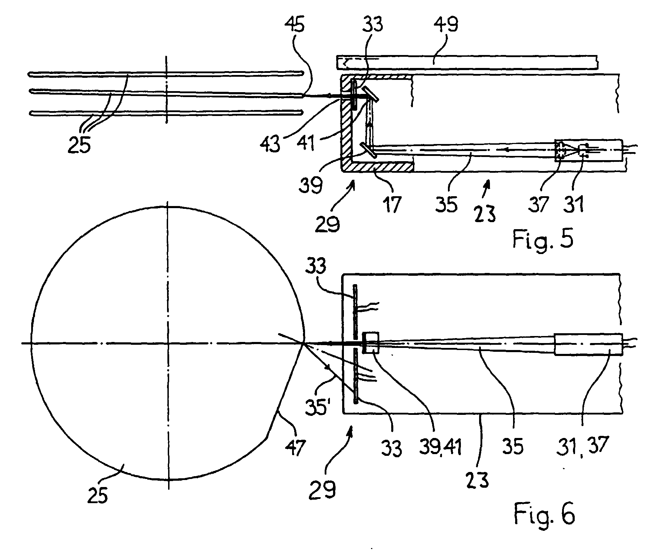

Auf dem Support 17 in der Längsachse des Arms 15 ist eine optische Detektionseinrichtung 29 angeordnet. In den Figuren 5 und 6 ist die Detektionseinrichtung 29 in vergrössertem Massstab dargestellt. Die Detektionseinrichtung 29 weist einen Lichtstrahlen aussendenden Sender 31 und einen Empfänger 33 auf. Die vom Sender 31 ausgesandten Lichtstrahlen 35 werden von einer Sammellinse 37 gebündelt und über die Umlenkspiegel 39,41 durch eine Oeffnung 43 des Supports 17 auf die Waferkante 45 fokussiert. Durch die relativ lange Brennweite von ungefähr 30 cm ergibt sich ein sehr schmaler Lichtstrahl 35, welcher an der Waferkante 45 einen Durchmesser von etwa 50 µm aufweist.

Die Anordnung des Empfängers 33 ist aus Fig.6 ersichtlich. Der Empfänger 33 erstreckt sich auf beide Seiten der Längsachse des Greifers 23, sodass ein Lichtstrahl 35, der auf einen seitlich orientierten Waferflat 47 eines Wafers 25 fällt, immer noch vom Empfänger 33 detektiert werden kann. Dadurch können mit dieser optischen Detektionseinrichtung 29 Wafer unabhängig von ihrer Orientierung in der Kassette 27 zuverlässig detektiert werden. Es ist denkbar, im Unterschied zur vorbeschriebenen Anordnung den Empfänger z.B. unten am Tragarm 49 anzuordnen, wobei die ausgesandten Lichtstrahlen 35 in einem kleinen Abstand zum Tragarm 49 auf die Waferkante fokussiert werden.

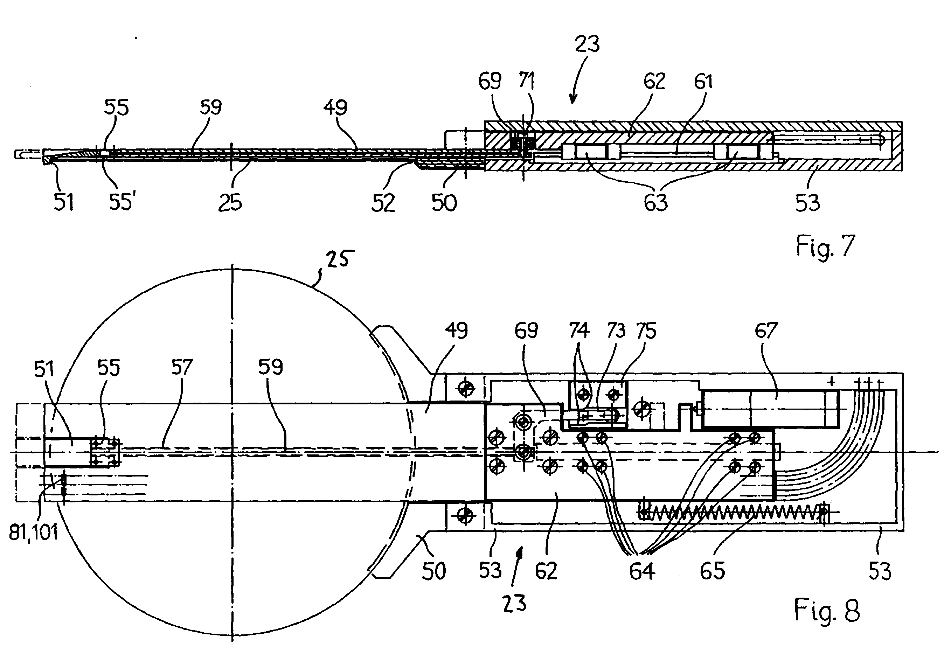

In den Figuren 7 und 8 ist ein Greifer 23 beim Erfassen eines Wafers 25 dargestellt. Der Greifer 23 weist einen in der Längsrichtung bewegbaren Tragarm 49 mit einem schwenkbaren Tragelement 51 auf. In einem ortsfesten Gehäuse 53 sind Mittel zum Verschieben des Tragarms 49 und zum Betätigen des Tragelements 51 untergebracht.

Das schwenkbare Tragelement 51 ist am äusseren Ende des Tragarms 49 in dessen Längsachse angeordnet. Das Tragelement 51 ist mittels zweier Blattfedern 55,55' am Tragarm 49 und an einer in einer Nut 57 des Tragarms 49 angeordneten Zugstange 59 befestigt.

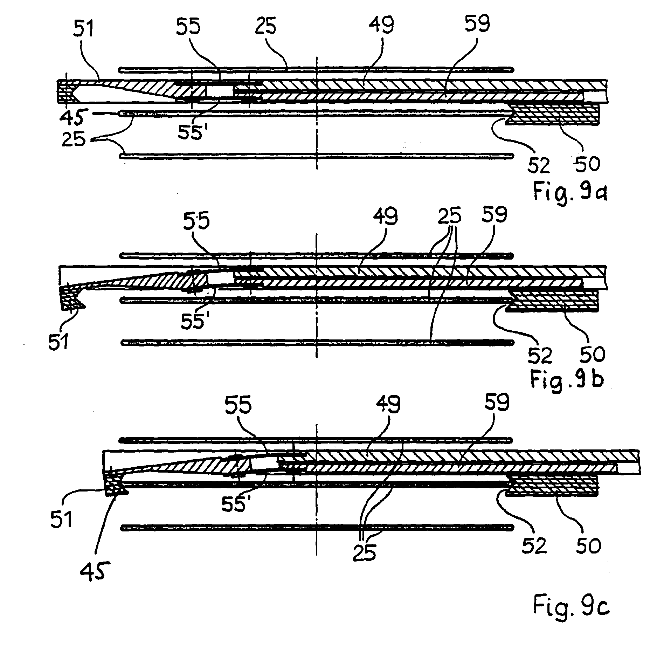

Der Tragarm 49 ist am gehäuseseitigen Ende an einer Platte 62 befestigt, welche mittels der Schrauben 64 an die Schlitten 63 festgeschraubt ist (Fig.7 und 8). Die Schlitten 63 werden durch die Schiene 61 geführt. Wie aus Fig.8 ersichtlich ist, ist die Platte 62 mit einer Zugfeder 65 und einem Druck- oder Vakuumzylinder 67 gekoppelt. Die Zugfeder 65 hält den Tragarm 49 in der Arbeitslage, d.h. der Tragarm 49 ist zurückgezogen, wenn der Druckzylinder 67 drucklos ist oder kein Vakuum angelegt ist, wie dies in Fig. 9c dargestellt ist. Durch Betätigen des Druck- oder Vakuumzylinders 67 kann der Tragarm 49 eine bestimmte Strecke entlang seiner Längsachse nach vorn verschoben werden, wie das in den Figuren 7 und 8 strichpunktiert eingezeichnet ist. Er nimmt dann die in Fig. 9a eingezeichnete Stellung ein.

Die Zugstange 59 ist am gehäuseseitigen Ende mit einem Winkelhebel 69 gelenkig verbunden. Die Zugstange 59 ist also lediglich an zwei Punkten befestigt, nämlich an der Blattfeder 55' und am Winkelhebel 69, und berührt den Tragarm 49 nicht. Der Winkelhebel 69 ist an der Platte 62 durch ein Kugellager 71 gelenkig befestigt und ist durch eine eine Nut 73 aufweisende Kulisse 75 geführt, welche am Gehäuse 53 befestigt ist. Die Nut 73 weist eine Stufe 74 auf, welche bei der Längsbewegung des Tragarms 49 nach hinten von der Lage von Fig. 9a in die Lage von Fig. 9c eine Auslenkung des Winkelhebels 69 bewirkt, sodass die Zugstange 59 das Tragelement 51 in die Arbeitslage bewegt. Wenn also der Zylinder 67 entspannt wird, bewegt sich der Tragarm 49 in die Stellung von Fig. 9c, und während dieser Bewegung wird das Tragelement 51 in die Arbeitslage abgesenkt.

Am Gehäuse 53 ist ein weiteres Tragelement 50 ortsfest angeordnet, das z.B. segmentförmig ausgebildet sein kann und zum Halten eines Wafers 25 eine Rinne 52 als Randanlage aufweisen kann. Es ist jedoch denkbar, dass das Tragelement 50 aus lediglich zwei oder mehreren punktförmigen Auflagen besteht, auf welchen der Wafer 25 aufliegt, resp. mit welchen ein Wafer 25 beim Erfassen in Kontakt kommt.

In der Fig.9 a bis c wird der zeitliche Ablauf beim Fassen eines Wafers 25 gezeigt. Dargestellt ist ein Längsschnitt entlang der Längsachse des Tragarms 49. In Fig.9a befindet sich der Tragarm 49 oberhalb eines zu greifenden Wafers 25, wobei das Tragelement 50 an der Waferkante 45 anliegt und das Tragelement 51 gegenüberliegend sich über die Waferkante 45 hinaus erstreckt. Zum Fassen des Wafers 25 wird der Tragarm 49 etwas zurückgezogen, sodass das Tragelement 51 in die Arbeitslage geschwenkt wird (Fig.9b). Anschliessend bewegen sich der Tragarm 49 und die Zugstange 59 zusammen in Richtung Gehäuse 53 (nicht eingezeichnet) und das Tragelement 51 fasst den Wafer 25 an der Waferkante 45 (Fig.9c). Es ist zu beachten, dass der Tragarm 49 und die Zugstange 59 sich nicht berühren. Ausserdem werden auch durch die Schwenkbewegung des Tragelements 51 keine Partikel gebildet, weil keine Drehführung oder anderweitige Lagerung des Tragelements 51 am äusseren Ende des Tragarms 49 nötig ist und somit keine Oberflächen aneinander reiben.

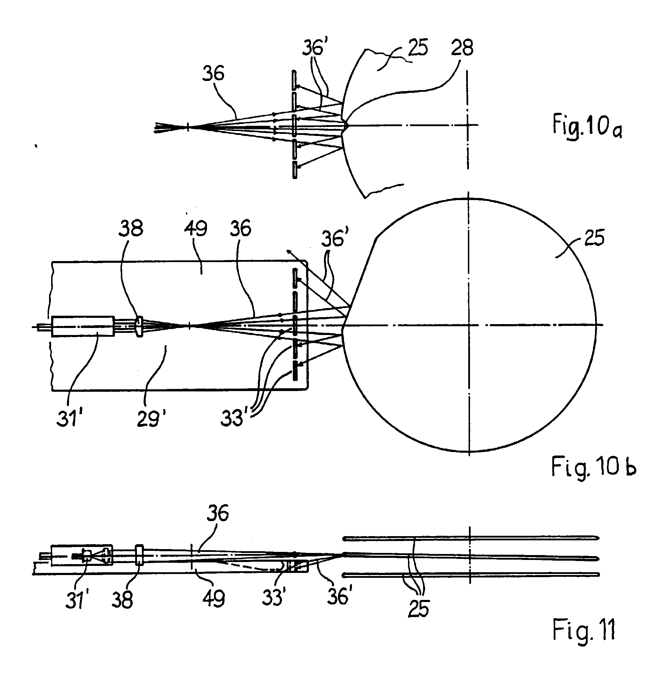

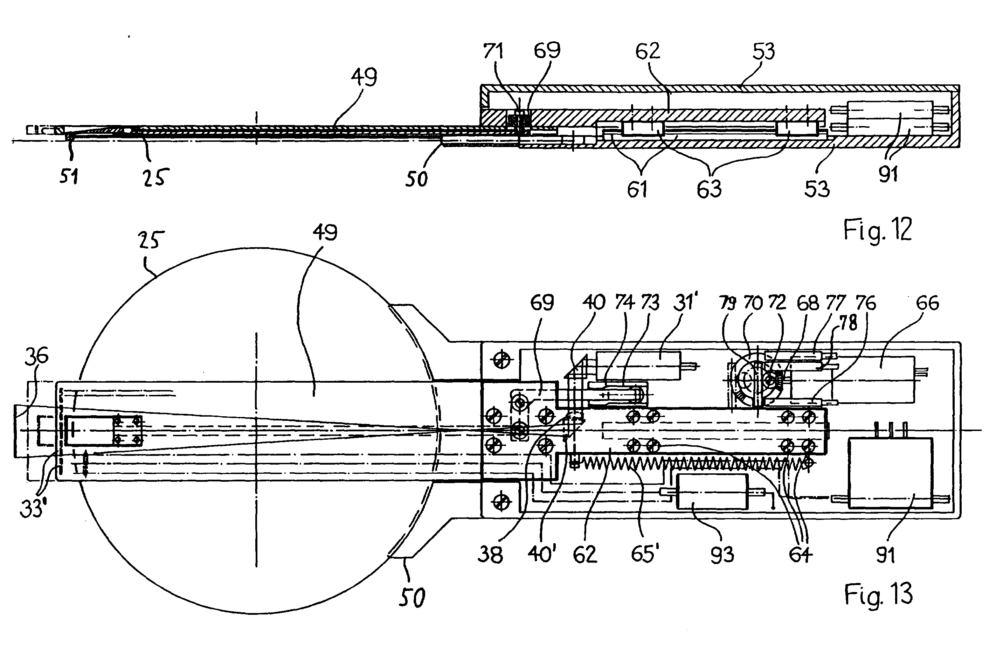

Die Detektionseinrichtung 29' gemäss den Figuren 10 und 11 unterscheidet sich von der weiter oben beschriebenen Einrichtung 29 (Figuren 5 und 6) darin, dass der vom Sender 31' ausgesandte Lichtstrahl 36 zu einem breiten, vorzugsweise zu den Waferscheiben 25 parallelen Strahl fokussiert ist. Dies kann am einfachsten durch eine Zylinderlinse 38 geschehen. Die beschriebene Anordnung hat den Vorteil, dass auch solche Wafer zuverlässig detektiert werden können, bei welchen der Waferflat oder eine Kerbe 28 (Innenseiten der Kerbe werden zur Kennzeichnung der Waferscheibe verwendet) nach vorne orientiert ist. Im Falle eines punktförmig fokussierten Lichtstrahls wird nämlich ein senkrecht in die Kerbe 28 fallender Strahl 36 praktisch wieder auf der selben Bahn reflektiert. Ein derart orientierter Wafer würde unter Umständen von der Detektionseinrichtung 29 der Figuren 5 und 6 nicht erkannt. Die Detektionseinrichtung 29' hat dank des breiten Lichtstrahls auch keine Mühe, Waferscheiben zu detektieren, deren Waferflat seitlich orientiert ist (Fig.10, b)). Die reflektierten Lichtstrahlen 36' werden von Empfängern 33' registriert, die an der Vorderkante des Tragarms 49 eingelassen sind.

Die Detektionseinrichtung 29' ist im Unterschied zur Einrichtung 29 der Figuren 5 und 6 am Greifer 23 angeordnet. Zwecks Vereinfachung der Beschreibung werden in den Fig. 12 und 13 weitgehend dieselben Bezugsnummern wie in den Fig. 7 und 8 verwendet (teilweise mit einem Apostroph "'" versehen). Wie insbesonders aus Fig.13 hervorgeht, ist der Sender 31', eine LASER-Quelle, im Gehäuse 53 untergebracht. Der ausgesandte Lichtstrahl wird über zwei Prismen 40,40' umgelenkt und durch die Zylinderlinse 38 zu einem breiten und flachen Lichtstrahl fokussiert. An der Vorderkante des Tragarms 49 weist der Lichtstrahl eine Breite von ca. 2 cm auf. Damit wird sichergestellt, dass wenigstens ein Teil des reflektierten Lichts auf die Empfängerdioden 33' trifft. Aus Kostengründen werden vorzugsweise mehrere in einer Reihe angeordnete Photodioden verwendet. Eine solche Anordnung bietet neben den günstigeren Gestehungskosten noch den Vorteil, dass die Signale der Dioden einzeln registriert werden können. Aus der Verteilung des reflektierten Lichts kann dann eine Aussage über die Lage eines Wafers gewonnen werden. Liegt ein Wafer z.B. von vorne gesehen schräg in der Kassette, so erzeugt das reflektierte Licht ein relativ schmales Maximum. Im Unterschied dazu ist das Maximum breit, wenn der Lichtstrahl und die Waferscheibe parallel zueinander sind.

Wie weiter aus der Fig.13 hervorgeht, ist zum Verschieben des Tragarms 49 und Betätigen des Tragelements 50 ein Motor 66 vorgesehen. Der elektronisch steuerbare Motor dreht ein erstes Kegelrad 68, welches mit einem zweiten Kegelrad 70 in Eingriff ist. Auf dem Kegelrad 70 ist ein Kugellager 72 exzentrisch in horizontaler Lage angeordnet. An diesem frei drehbaren Kugellager 72 liegt der Stift 79 an, welcher mit der Platte 62 fest verbunden ist. Der Stift 79 wird durch die unter Spannung stehende Feder 65' an das Kugellager 72 gedrückt. Das Kugellager 72 hilft die Entstehung von Partikeln durch Reibung zu vermeiden.

Nicht aus der Darstellung ersichtliche Anschläge, welche mit Vorsprüngen am Kegelrad 70 zusammenwirken, beschränken die Drehung des Kegelrades 70. Im gezeigten Ausführungsbeispiel wird die maximale Drehung des Kegelrades 70 durch zwei Anschläge auf 180 Grad beschränkt. Die Lagefeststellung erfolgt durch die Schalter oder Initiatoren 76,77, welche die Endpositionen des Kegelrades 70 feststellen können.

Ein weiterer Initiator 78 wirkt mit dem Stift 79 zusammen. Halten die Tragelemente 50,51 einen Wafer im Eingriff, so befindet sich der Stift 79 in Abstand zum Initiator 78 und der Initiator schaltet nicht. Wäre hingegen durch eine Fehlmanipulation kein Wafer im Eingriff oder würde dieser während des Transports fallengelassen, so würde der Initiator betätigt.

Im Gehäuse von Figur 13 ist noch ein Durchfluß- oder Druckmeßgerät 91 und eine Mikropumpe 93 untergebracht, welche für die Distanzmessung mittels des nachfolgend beschriebenen Fluidsensors 81 benötigt werden.

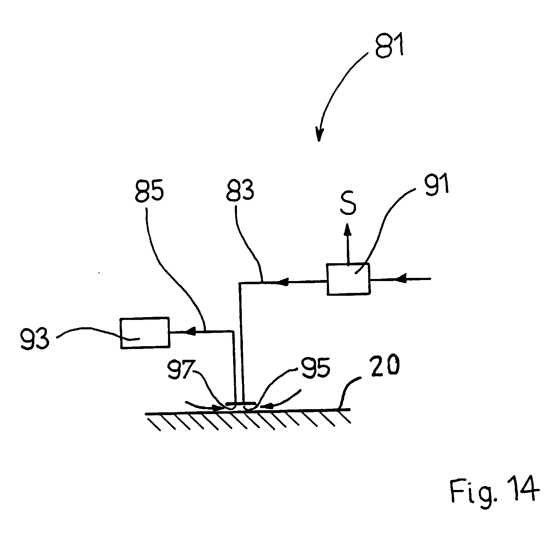

Der vorzugsweise eingesetzte Fluidsensor 81 weist zwei Oeffnungen 95,97 auf, welche in Abstand voneinander am Tragarm 49 oder z.B. an einem separaten Sensorkopf angeordnet sind (Fig.14). Die erste Oeffnung 97 ist an einen Kanal 85 angeschlossen, der mit einer Unterdruckquelle 93, z.B. einer Pumpe, in Verbindung steht. Die Unterdruckquelle 93 kann ein gasförmiges Medium, z.B. Luft, durch den Kanal 85 ansaugen. Befindet sich eine zu fühlende Oberfläche 20 in kleinem Abstand vom Sensorkopf, so erhöht sich die Gasströmung zwischen dem Sensorkopf und der Oberfläche 20, sodass vor der zweiten Oeffnung 95 ein Unterdruck entsteht. Dieser Unterdruck induziert eine Gasströmung im Kanal 83. Der Kanal 83 steht in Verbindung 87 mit einem Durchfluss- oder einem Druckmessgerät 91 und weist einen Eingang auf. Die Gasströmung resp. der Unterdruck im Kanal 83 kann vom Durchfluss- oder Druckmessgerät 91 gemessen werden. Das Messignal S kann dann anhand der vorher bestimmten Kennlinie des Sensors 81 in einen Abstandswert umgerechnet werden.

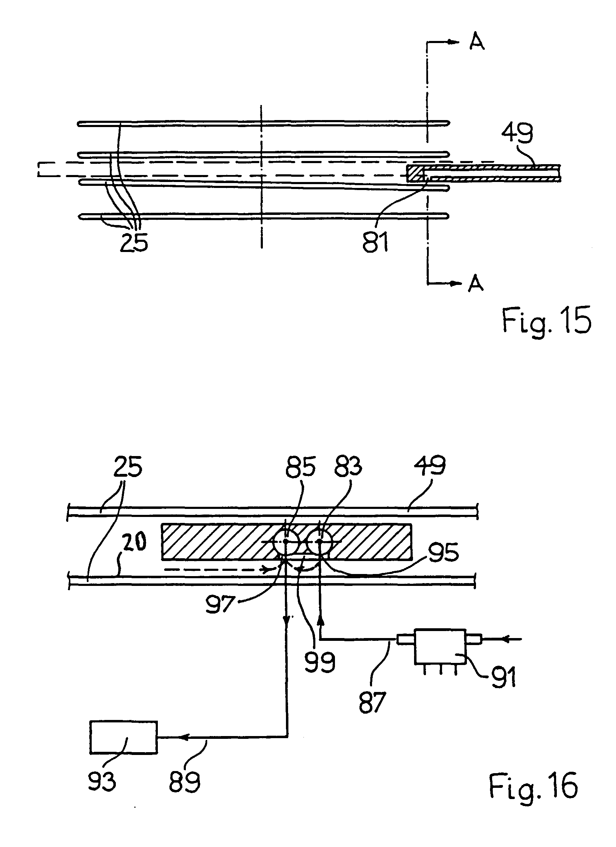

Die Figuren 15 und 16 zeigen eine erste Ausführungsart eines Fluidsensors 81, welcher im Tragarm 49 integriert ist. Die Oeffnungen 95,97 der beiden Kanäle 83,85 sind in einem Abstand voneinander in der Oberfläche des Tragarms 49 angeordnet. Der Durchmesser der Oeffnungen 95,97 kann je etwa 1 mm betragen. Die Oeffnungen 95,97 sind in einem Abstand von ca.0.5 mm voneinander angeordnet und durch eine etwa 0.8 mm tiefe Rinne 99 miteinander verbunden sein. Die Rinne 99 sorgt dafür, dass die Gasströmung im Kanal 83 auch bei Abständen des Sensorkopfes von <100 µm von der zu fühlenden Oberfläche 20 nicht zusammenbricht. Es ist möglich, den Abstand der beiden Oeffnungen am Sensorkopf in einem gewissen Ausmass zu variieren.

Der Einfluss der Rinne 99 auf den Verlauf der Kennlinie (Kurven A und B) des Sensors 81 ist in Fig. 18 gezeigt. Im Diagramm der Fig.18 ist auf der Ordinate das Messignal des Durchflussmessgerätes in Volt als Funktion des Abstandes des Sensors von der zu fühlenden Oberfläche 20 aufgetragen. Bei einem Abstand von etwa <100 µm des Sensors 81 von der zu fühlenden Oberfläche 20 bricht die Gasströmung im Kanal 83 zusammen und die Kennlinie weist ein Maximum auf (Kurve B). Werden die Oeffnungen 95,97 des Sensors jedoch durch eine Rinne, wie dies beim Ausführungsbeispiel gemäss Figur 16 gezeigt ist, miteinander verbunden, so fällt die Kurve auch bei sehr kleinen Abständen zwischen Sensorkopf und Oberfläche 20 nicht mehr ab (Kurve A).

Beim Betrieb des Sensors 81 unter Normaldruck wird im Kanal 85 zweckmässigerweise ein Druck zwischen 10 mbar und 500 mbar, vorzugsweise zwischen 50 mbar und 200 mbar, erzeugt. Dadurch ergibt sich eine steile Kennlinie des Sensors 81 bei Abständen des Sensorkopfes von bis zu etwa 1 mm von der zu fühlenden Oberfläche 20.

Der Vorteil des Sensors 81 liegt darin, dass die Umgebungsatmosphäre angesaugt wird und kein Gas, wie bei den mit einem Ueberdruck arbeitenden Fluidsensoren, auf die empfindlichen Waferoberflächen geblasen wird.

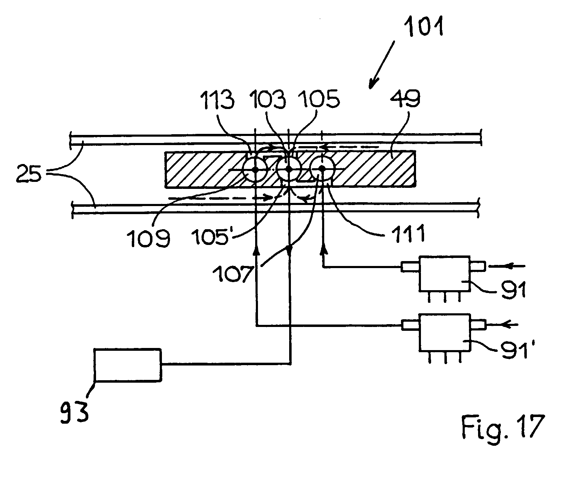

Fig. 17 zeigt wie bereits Fig. 16 einen Querschnitt durch einen Tragarm 49, jedoch mit dem Unterschied, dass im Tragarm 49 ein Doppel-Fluidsensor 101 integriert ist, welcher den Abstand in zwei entgegengesetzten Richtungen misst. Dieser Doppel-Fluidsensor 101 lässt sich zweckmässig herstellen, indem ein zentraler Kanal 103 vorgesehen wird, welcher je eine Kanalöffnung 105 nach oben und eine Kanalöffnung 105' nach unten aufweist. Dementsprechend weist der Messkanal 107 eine Oeffnung 111 nach unten, der Messkanal 109 eine Oeffnung 113 nach oben auf, sodass durch zwei Durchflussmessgeräte 91,91' die Abstände des Tragarms 49 zu zwei benachbarten Wafern 25 gleichzeitig gemessen werden kann.

### Arbeitsweise der Transportvorrichtung

Zu Beginn einer Transportoperation, z.B. Holen eines Wafers 25 aus einer Kassette 27, wird der Arm 15 resp. Greifer 23 soweit um die durch die Säule 13 gehende Längsachse gedreht, bis der Arm 15 senkrecht und in einem Abstand zur Frontseite der Kassette 27 steht. Es wird dabei angenommen, dass die Kassette 27 vorgängig an einer durch den Arm 15 erreichbaren Stelle aufgestellt wurde. Um den an einer bestimmten Position in der Kassette 27 liegenden Wafer fassen zu können, wird die Säule 13 zuerst entlang ihrer Längsachse bewegt. Die optische Detektionseinrichtung 29 kann dabei gleichzeitig durch Detektion der an den einzelnen Waferkanten 45 reflektierten Lichtstrahlen 35 die einzelnen Wafer 25 erfassen. Ist der Greifer 49 des Arms 15 an der gewünschten Position angelangt, so wird der Arm 15 resp. der Greifer 23 in Längsrichtung bewegt und so justiert, dass der Tragarm 49 zwischen zwei Wafer berührungsfrei in die Kassette 27 eingreifen kann. Dazu kann z.B. vorgängig der Abstand der beiden benachbarten Waferkanten 45 bestimmt werden. Sollte der Abstand zu klein sein, so kann die Transportoperation abgebrochen und/oder eine Meldung an einem die Vorrichtung 11 resp. die Transportoperationen steuernden und überwachenden Computer 10 ausgegeben werden.

Als zweckmässig hat sich erwiesen, dass beim Holvorgang eines bestimmten Wafers (25) gleichzeitig jeweils die Position des nächstliegenden Wafers erfasst und gespeichert wird. Dies wird durch die im Arm 15 angebrachte Detektionseinrichtung 29 vorteilhaft ermöglicht. Durch dieses vorgängige Erfassen kann wertvolle Zeit eingespart werden. Befindet sich z.B. im nächstliegenden Fach der Waferkassette 27 kein Wafer 25, so wird automatisch die nächste Position erfasst, sodass der Tragarm 49 nie in ein leeres Fach eingreift.

Wenn der lichte Abstand zweier Wafer 25 genügend gross ist, so wird der Tragarm 49 in die Kassette 27 bewegt. Gleichzeitig messen die im Tragarm 49 integrierten Fluidsensoren 81 die Abstände zu den benachbarten Wafern 25. Falls einer der beiden Abstände einen bestimmten Schwellwert unterschreitet, so wird die Transportbewegung gestoppt und die Position des Tragarms 49 automatisch z.B. durch eine Nachlaufsteuerung korrigiert. Dies ist z.B. dann der Fall, wenn einer oder beide Wafer 25 aufgrund einer seitlichen Orientierung des Waferflat geneigt in der Kassette 27 liegen. Sollte der Abstand des Tragarms 49 zu den benachbarten Wafern 25 jedoch zu gering sein, so wird die Transportoperation abgebrochen.

Um bei nötigen Korrekturbewegungen des Tragarms 49 eine Kollision zwischen der vorderen Waferkante 45 eines Wafer 25, welcher vorne nach unten geneigt ist, und der Unterseite des Tragarms 49 zu vermeiden, wird die Kassette 27 beim Positionieren vorteilhaft etwas nach hinten geneigt. Durch diese zweckmässige Massnahme kann die Schräglage der Wafer 25 etwas ausgemittelt werden.

Falls die Abstände des Tragarms 49 zu den benachbarten Wafern 25 genügend gross sind, wird der Tragarm 49 soweit in die Kassette 27 bewegt, bis die Rinne 52 des segmentförmigen Tragelements 51 an der Waferkante 45 anliegt. Dann wird der Druck- oder Vakuumzylinder 67 entspannt, worauf sich der Tragarm 49 durch die Kraft der Zugfeder 65 in Richtung Gehäuse 53 bewegt. Dabei wird die Zugstange 59 durch Auslenkung des Winkelhebels 69, welcher in einem eine Stufe 74 aufweisenden Nut 73 geführt ist, zurückgezogen, wodurch das Tragelement 51 in die Arbeitslage schwenkt. Die Waferscheibe 25 wird sodann beim weiteren Zurückziehen des Tragarms 49 durch das Tragelement 51 an der Waferkante 45 gefasst. Der zwischen den Tragelementen 50,51 eingeklemmte Wafer 25 wird sodann etwas angehoben und aus der Kassette geholt.

## Patentansprüche

1. Vorrichtung zum Transportieren von flachen Gegenständen (25), insbesondere von Substraten, z.B. Wafern, aus einer eine Vielzahl von Ladeflächen aufweisenden Kassette (27) in eine andere Kassette (27) oder aus einer Kassette (27) in eine Bearbeitungsstation oder dergleichen, mit einem beweglichen Greifer (23), welcher einen Tragarm (49) und Mittel (50,51) zum Halten des flachen Gegenstandes aufweist, dadurch gekennzeichnet, dass am Tragarm (49) wenigstens ein Distanzsensor (81,101) vorgesehen ist, welcher während einer Holbewegung die Distanz zu wenigstens einem zum Tragarm (49) benachbarten flachen Gegenstand (25) misst.

2. Vorrichtung nach Anspruch 1, dadurch gekennzeichnet, dass der Sensor (81,101) ein von einem Gas durchströmter Fluidsensor ist.

3. Vorrichtung nach Anspruch 2, dadurch gekennzeichnet, dass der Fluidsensor (81,101) wenigstens zwei in Abstand voneinander angeordnete Oeffnungen (95,97) aufweist, wobei die erste Oeffnung (97) an einen ersten Kanal (85) angeschlossen ist, der mit einer Unterdruckquelle (93) in Verbindung steht, und die zweite Oeffnung (95) mit einem zweiten Kanal (83) in Verbindung steht, der einen Einlass für ein gasförmiges Fluidum aufweist und mit einem Durchfluss- oder Druckmessgerät (91) in Verbindung steht, welches eine Strömung oder eine Druckänderung im zweiten Kanal messen kann.

4. Vorrichtung nach Anspruch 3, dadurch gekennzeichnet, dass die Oeffnungen (95,97) der Kanäle (83,85) durch eine Rinne (99) miteinander verbunden sind.

5. Vorrichtung nach einem der Ansprüche 3 oder 4, gekennzeichnet durch eine der ersten Öffnung (105) gegenüberliegende weitere erste Oeffnung (105') die ebenfalls mit dem ersten Kanal (103) in Verbindung steht, und eine weitere zweite Oeffnung (111 oder 113) eines weiteren zweiten Kanales (107 oder 109), wobei die zweiten Öffnungen (111,113) jeweils in Abstand zu einer ersten Oeffnung (105,105') angeordnet sind.

6. Vorrichtung nach einem der Ansprüche 2 bis 5, dadurch gekennzeichnet, dass der Fluidsensor (81,101) im Tragarm (49) integriert ist.

7. Vorrichtung nach einem der Ansprüche 1 bis 6, dadurch gekennzeichnet, dass ein optisches Detektionssystem (29,29') mit einem Sender (31,31') und einem Empfänger (33,33') zur Feststellung der Lage des zu holenden Gegenstandes (25) vorgesehen ist.

8. Vorrichtung nach Anspruch 7, dadurch gekennzeichnet, dass die vom Sender (31,31') ausgesandten Lichtstrahlen ungefähr rechtwinklig auf die Gegenstandskante (45) gerichtet sind, und dass der Empfänger (33,33') sich auf wenigstens zwei Seiten des gesendeten Lichstrahls (35) erstreckt, sodass in einem Winkel reflektiertes Licht detektiert werden kann.

9. Vorrichtung nach Anspruch 7 oder 8, dadurch gekennzeichnet, dass die optische Detektionseinrichtung (29) eine Laserlichtquelle, eine Fokussieroptik und gegebenenfalls Umlenkspiegel (39,41) oder -Prismen (40,40') und ein Photoelement (33,33') aufweist.

10. Vorrichtung nach einem der Ansprüche 7 bis 9, dadurch gekennzeichnet, dass die Detektionseinrichtung (29) in oder auf einem Support (17) des Greifers (23) angeordnet ist und dass der ausgesandte Lichtstrahl (35) durch eine Sammellinse (37) ungefähr punktförmig gebündelt wird.

11. Vorrichtung nach Anspruch 10, dadurch gekennzeichnet, dass der Empfänger (33) in einem Abstand < 20 mm zur Gegenstandskante (45) angeordnet ist.

12. Vorrichtung nach einem der Ansprüche 7 bis 11, dadurch gekennzeichnet, dass der Sender (31') der Detektionseinrichtung (29') am Greifer (23) und der Empfänger (33') am gehäusefernen Ende des Tragarms (49) angeordnet sind.

13. Vorrichtung nach einem der Ansprüche 7 bis 12, dadurch gekennzeichnet, dass der vom Sender (31') ausgesandte Lichtstrahl zu einem breiten und flachen Strahl fokussiert ist.

14. Vorrichtung nach einem der Ansprüche 1 bis 13, dadurch gekennzeichnet, dass der Greifer (23) einen entlang seiner Längsachse verschiebbaren Tragarm (49), Mittel zum Verschieben des Tragarms (49), mindestens ein erstes, ortsfestes Tragelement (50) sowie ein zweites, am Tragarm (49) schwenkbar angeordnetes Tragelement (51) und Mittel zum Schwenken des Tragelements (51) aufweist.

15. Vorrichtung nach Anspruch 14, dadurch gekennzeichnet, dass das zweite Tragelement (51) mittels Blattfedern (55,55') am Tragarm (49) und an einer bezüglich des Tragarms (49) verschiebbaren Zugstange (59) schwenkbar befestigt ist.

16. Vorrichtung nach einem der Ansprüche 1 bis 15, dadurch gekennzeichnet, dass der Tragarm (49) gehäuseseitig an einer Platte (62) befestigt ist, die ihrerseits fest mit zwei entlang einer Führungsschiene (61) bewegbaren Schlitten (63) verbunden ist, die durch Beaufschlagen eines Druck- oder Vakuumzylinders (67) oder durch einen elektronisch steuerbaren Motor (91) entgegen der Kraft einer Zugfeder (65,65') von der Arbeitslage in die Ruhelage bewegbar sind.

17. Vorrichtung nach einem der Ansprüche 1 bis 16, dadurch gekennzeichnet, dass ein mit dem Tragarm (49) verbundener Stift (79) derart mit einem Schalter (78) zusammenwirkt, dass der Schalter (78) beim Zurückziehen des unter Federspannung stehenden Tragarms (49) betätigt wird, wenn die Tragelemente (50,51) keinen Gegenstand (25) im Eingriff halten.

18. Vorrichtung nach den Ansprüchen 15 und 16, dadurch gekennzeichnet, dass ein an der Platte (62) schwenkbar angeordneter Winkelhebel (69) die Zugstange (59) mit einer ortsfesten Kulisse (75) gelenkig verbindet, wobei der Winkelhebel (69) in einer eine Stufe (74) aufweisenden Nut (73) der Kulisse (75) derart geführt ist, dass beim Verschieben der Platte (62) die Zugstange (59) relativ zum Tragarm (49) bewegt und somit das zweite Tragelement (51) geschwenkt wird.

19. Vorrichtung nach einem Anspruch 15 einschließenden, vorangehenden Anspruch, dadurch gekennzeichnet, dass die Zugstange (59) sich in einer Nut (57) des Tragarms (49) von der Blattfeder (55') zum Winkelhebel (69) erstreckt, wobei die Zugstange (59) den Tragarm (49) nicht berührt.

20. Vorrichtung nach einem Anspruch 14 einschließenden, vorangehenden Anspruch, dadurch gekennzeichnet, dass das zweite Tragelement (51) in der Ruhelage etwa bündig mit der Oberfläche des Tragarms (49) ist und in der Arbeitslage den Tragarm (49) um mindestens die Stärke eines Wafers (25) überragt.

21. Vorrichtung nach einem Anspruch 14 einschließenden, vorangehenden Anspruch, dadurch gekennzeichnet, dass das zweite Tragelement (51) winkelförmig ausgebildet ist.

22. Vorrichtung nach einem Anspruch 10 einschließenden, vorangehenden Anspruch, dadurch gekennzeichnet, dass der Greifer (23) an einem Schlitten (21) befestigt ist, welcher entlang einer auf dem Support (17) angeordneten Linearführung (19) verschiebbar ist.

23. Vorrichtung nach einem der Ansprüche 1 bis 22, dadurch gekennzeichnet, dass der Greifer (23) entlang einer senkrecht zu seiner Längsachse stehenden Achse (14) verschiebbar und um diese frei drehbar ist.

24. Verfahren zum Transportieren von flachen Gegenständen (25), insbesondere von Substraten, z.B. Wafern, aus einer eine Vielzahl von Ladeflächen aufweisenden Kassette (27) in eine andere Kassette (27) oder aus einer Kassette (27) in eine Bearbeitungsstation oder dergleichen, mit einem beweglichen Greifer (23), wobei beim Holvorgang zuerst die Position der vorderen Gegenstandskante (45) des zu transportierenden Gegenstands (25) ermittelt wird, indem Lichtstrahlen ungefähr rechtwinklig auf die Gegenstandskante (45) gerichtet und das reflektierte Licht durch einen Empfänger (33,33') detektiert wird, und der Greifer (23) anschliessend in einen der zum besagten Gegenstand (25) benachbarten Zwischenräume eingreift und soweit in die Kassette (27) bewegt wird, bis er den Gegenstand (25) in Eingriff nehmen kann, diesen nach der Ineingriffnahme etwas anhebt und aus der Kassette (27) entfernt, dadurch gekennzeichnet, dass am Tragarm (49) ein Distanzsensor (81,101) vorgesehen ist, welcher den Abstand des Tragarms (49) zu wenigstens einem der nächstliegenden Gegenstände (25) misst, sodass die Position des Tragarms (49) oder der Kassette (27) durch eine Nachlaufsteuerung automatisch in der Weise korrigiert werden kann, dass der Tragarm (49) keinen Gegenstand (25) berührt.

25. Verfahren nach Anspruch 24, dadurch gekennzeichnet, dass der Abstand zu beiden zum Tragarm (49) benachbarten Gegenständen (25) kontinuierlich gemessen wird.

26. Verfahren nach Anspruch 24 oder 25, dadurch gekennzeichnet, dass der Gegenstand (25) in Eingriff genommen wird, indem ein Tragelement (51) aus der Ebene des Tragarms (49) geschwenkt und zum Gegenstand (25) hin gezogen wird.

## Claims

1. Device for transporting flat objects (25), in particular substrates, e.g. wafers, from a cassette (27) having a plurality of loading areas to another cassette (27), or from a cassette to a process station or the like, with a movable gripper (23) comprising a support arm (49) and means for holding the flat object, characterized in that the support arm is provided with at least one distance sensor (81,101) which measures the distance to at least one flat object (25) being adjacent to the support arm (49) during a transportation sequence.

2. Device according to claim 1 characterized in that the sensor (81,101) is a fluidic sensor with a flow-through gas flux.

3. Device according to claim 2 characterized in that the fluidic sensor (81,101) comprises at least two spaced-apart apertures (95,97) whereas the first aperture (97) is connected to a first channel (85) being in connection with to a negative pressure source (93), and the second aperture (95) is connected to a second channel (83) having an inlet for gas-like fluid and being in connection with a flux or pressure measuring device (91) to measure a change of flux or pressure in the second channel.

4. Device according to claim 3 characterized in that the apertures (95,97) of the channels (83,85) are in connection with each other by a groove (99)

5. Device according to claim 3 or 4 characterized by a further aperture (105') being opposite to the aperture (105), the aperture (105') being in connection with the first channel (103) as well, and a further second additional aperture (111 or 113) of a further second channel (107 or 109) whereas the second apertures (111,113) are arranged at a distance to the a first aperture (105,105').

6. Device according to any of claims 2 to 5 characterized in that the fluidic sensor (81,101) is integrated in the support arm (49).

7. Device according to any of claims 2 to 5 characterized in that an optical detection system (29,29') is provided, the system (29,29') having a transmitter (31,31') and a receiver (33,33') to determine the position of the object (25) to be transported.

8. Device according to claim 7 characterized in that the light beams emitted by the transmitter (31,31') are orientated approximately at a right angle to the edge of the object (45) and that the receiver (33,33') extends to both sides of the emitted light beam (35) in order to be able to detect light reflected at an angle.

9. Device according to claim 7 or 8 characterized in that the optical detection system (29) comprises a laser light source, a focussing optic and, if necessary, a deflection mirror (39,41) or -prism (40,40') and a photoelement (33,33').

10. Device according to any of claims 7 to 9 characterized in that a detection system (29) is arranged in or on a support (17) of the gripper (23), and that the emitted light beam (35) is focussed by a focussing lens (37) approximately to a dot.

11. Device according to claim 10 characterized in that the receiver (33) is located at a distance of less than 20 mm with respect to the edge of the object (45).

12. Device according to any of claims 7 to 11 characterized in that the transmitter (31') of the detection system (29') is mounted on the gripper (23), and the receiver (33') mounted at the far end of the support arm (49).

13. Device according to any of claims 7 to 12 characterized in that the light beam emitted by the transmitter (31') will be focussed to a broad and flat beam.

14. Device according to any of claims 1 to 13 characterized in that the gripper (23) is provided with a support arm (49) being movable in the longitudinal axis, means for moving the support arm (49), at least a fixed support element (50) and a second tiltable support element (51) attached to the support arm (49) and means for tilting the support element (51).

15. Device according to claim 14 characterized in that the second support element (51) is fixed to the support arm (49) and to an activating bar being movable with respect to the support arm (49) by means of leave springs (55,55').

16. Device according to any of claims 1 to 15 characterized in that the support arm (49) is attached on the side of the housing to a plate (62) which itself is connected firmly to two slides (63) being movable along a guide rail (61), the guide rail (61) being movable against spring force from a working position into a idle position by activating a pressure or vacuum cylinder (65,65') or controlling an electrical motor (91).

17. Device according to any of claims 1 to 16 characterized in that a pin (79) connected with the support arm (49) cooperates with a switch (78) in such a way that the switch (78) is activated, when the support arm (49) is retracted against spring force, only in the case when the support elements (25) have grasped no objects (25)

18. Device according to claim 15 and 16 characterized in that a bell crank (69) being tiltably attached to the plate (62) jointedly links the activating bar (59) with a fixed cullisse (75) whereas the bell crank (69) is guided in a groove (73) of the culisse (75) such that by moving the plate (62) the activating bar (59) is moved relatively to the support arm (49) and thereby tilts the second support element (51).

19. Device according to a preceding claim, including claim 15, characterized in that the activating bar (59) extends from the leave spring (55') to the bell crank ( 69) in a groove of the support arm (49) whereas the activating bar (59) does not touch the support arm (49).

20. Device according to a preceding claim, including claim 15, characterized in that the second support element (51) in idle position is approximately flush with the surface of the support arm (49) and in the working position exceeds the support arm (49) by at least the thickness of the wafer.

21. Device according to a preceding claim, including claim 15, characterized in that that the second support element (51) is angularly shaped.

22. Device according to a preceding claim, including claim 15, characterized in that the gripper (23) is attached to a slide (21) which is movable along a linear guidance (19) arranged on the support (17).

23. Device according to any of claims 1 to 22 characterized in that the gripper (23) is movable along and rotatable about an axis (14) being perpendicular orientated to its longitudinal axis.

24. Process for transporting flat objects (25), in particular substrates, e.g. wafers, from a cassette (27) having a plurality of loading areas to another cassette (27) or from a cassette to a process station or the like, with a movable gripper (23) whereby during the grasping action the position of the front edge (45) of the object (25) to be transported is determined by directing light beams essentially perpendicular onto the edge (45) of the object and detecting the reflected light by a receiver (33,33'), and the gripper (23) moving subsequently into one of spaces adjacent to said object (25) and into the cassette (27) until it can grasp the object (25), and after having grasped the object lifting it a little bit and removing it out from the cassette (27) **characterized in that** the support arm (49) is provided with a distance sensor (81,101) for measuring the distance between the support arm (49) and at least one of the adjacent objects so that the position of the support arm (49) or of the cassette (27) can be corrected automatically by means of a fly back control process in a way that the support arm (49) does not touch an object.

25. Method according to claim 24 characterised in that the distance between the support arm (49) and both objects (25) being adjacent to the support arm (49) is measured continuously.

26. Method according to claim 24 or 25 characterised in that the object (25) is grasped by tilting a support element (51) out of the plane of the support arm (49) and retracting it towards the object (25).

## Revendications

1. Appareil pour transporter des objets plats (25), en particulier des substrats, par exemple, des plaquettes, d'une cassette (27) munie de plusieurs sites de chargement à une autre cassette (27) ou d'une cassette à une station process ou similaire, avec un crampon mobile (23) comprenant un bras de support (49) et les moyens de tenir l'objet plat, caractérisé par le fait que le bras de support est muni d'au moins un capteur de distance (81, 101) qui mesure la distance à au moins un objet plat (25) adjacent au bras de support (49) pendant une séquence de transport.

2. Appareil selon la revendication 1 caractérisé par le fait que le capteur (81, 101) est un capteur à fluide traversé par un flux gazeux.

3. Appareil selon la revendication 2 caractérisé par le fait que le capteur fluide (81, 101) comprend au moins deux ouvertures séparées (95,97), dont la première ouverture (97) est reliée à un premier canal (85) qui est relié à une source de pression négative (93), et la deuxième ouverture (95) est reliée à un deuxième canal (83) avec une admission pour un fluide gazeux et qui a un appareil pour mesurer le flux ou la pression (91) pouvant mesurer une modification du flux ou de la pression dans le deuxième canal.

4. Appareil selon la revendication 3 caractérisé par le fait que les ouvertures (95, 97) des canaux (83, 85) sont liées l'une à l'autre par une rainure (99).

5. Appareil selon les revendications 3 ou 4 caractérisé par une ouverture supplémentaire (105') en face de l'ouverture (105), l'ouverture (105') étant elle aussi reliée au premier canal (103), et une deuxième ouverture supplémentaire (111 ou 113) d'un deuxième canal supplémentaire (107 ou 109) tandis que les deuxièmes ouvertures (111, 113) sont disposées à une certaine distance de la première ouverture (105, 105').

6. Appareil selon toutes les revendications 2 à 5 caractérisé par le fait que le capteur à fluide (81, 101) est intégré dans le bras de support (49).

7. Appareil selon toutes les revendications 2 à 5 caractérisé par le fait qu'un système de détection optique (29, 29') est fourni. Ce système (29, 29') est équipé d'un émetteur (31, 31') et d'un récepteur (33, 33') pour déterminer la position de l'objet (25) à transporter.

8. Appareil selon la revendication 7 caractérisé par le fait que les faisceaux lumineux émis par l'émetteur (31, 31') sont orientés approximativement avec un angle droit par rapport au bord de l'objet (45) et que le récepteur (33, 33') est disposé sur les deux côtés du faisceau de lumière émis (35) pour permettre la détection de la lumière réfléchie selon un angle.

9. Appareil selon les revendications 7 ou 8 caractérisé par le fait que le système de détection optique (29) comprend une source de lumière laser, une optique de focalisation et, si nécessaire, un miroir (39,41) ou un prisme (40, 40') déflecteur et un photoélément (33, 33').

10. Appareil selon toutes les revendications 7 à 9 caractérisé par le fait qu'un système de détection (29) est disposé dans ou sur un support (17) du crampon (23), et que le faisceau de lumière (35) émis est focalisé par une lentille de focalisation (37) à approximativement un point.

11. Appareil selon la revendication 10 caractérisé par le fait que le récepteur (33) est situé à une distance inférieure à 20 mm par rapport au bord de l'objet. (45).

12. Appareil selon toutes les revendications 7 à 11 caractérisé par le fait que l'émetteur (31') du système de détection (29') est monté sur le crampon (23) et le récepteur (33') est monté à l'extrémité du bras de support (49).

13. Appareil selon toutes les revendications 7 à 12 caractérisé par le fait que le faisceau de lumière émis par l'émetteur (31') sera focalisé selon un faisceau large et plat.

14. Appareil selon toutes les revendications 1 à 13 caractérisé par le fait que le crampon (23) est muni d'un bras de support (49) mobile selon l'axe longitudinal, un moyen pour bouger le bras de support (49), au moins un élément de support fixe/immobile (50) et un deuxième élément de support inclinable (51) fixé au bras de support (49) et un moyen pour incliner l'élément de support (51).

15. Appareil selon la revendication 14 caractérisé par le fait que le deuxième élément de support (51) est fixé au bras de support (49) et à une barre d'activation qui est mobile par rapport au bras de support (49) au moyen de lamelles ressorts (55,55').

16. Appareil selon toutes les revendications 1 à 15 caractérisé par le fait que le bras de support (49) est attaché au côté du boîtier à une plaque (62) qui est elle-même reliée fermement à deux coulisses (63) mobiles le long d'une glissière (guide rail) (61), la glissière (61) étant mobile contre la force du ressort d'une position de fonctionnement à une position de repos par l'activation d'un cylindre à pression ou à vide (65, 65') ou la commande d'un moteur électrique (91).

17. Appareil selon toutes les revendications 1 à 16 caractérisé par le fait qu'une pointe (79) reliée au bras de support (49) coopère avec un interrupteur (78) de manière à ce que l'interrupteur (78) soit activé, lorsque le bras de support (49) est rétracté contre la force du ressort, uniquement au cas où les éléments de support (25) n'ont saisi aucun objet (25).

18. Appareil selon revendications 15 et 16 caractérisé par le fait qu'une bande courbe est attachée d'une manière inclinable à la plaque (62) relie d'une manière articulée la barre d'activation (59) avec une cullisse fixe (75) tandis que la manivelle (69) est guidée dans une rainure (73) de la coulisse (75) de manière à ce que, en déplaçant la plaque (862), la barre d'activation (59) est déplacée relativement au bras de support (49) et de cette façon incline le deuxième élément de support (51).

19. Appareil selon une revendication précédente, y compris revendication 15, caractérisé par le fait que la barre d'activation (59) s'étend du ressort à lames (55') au levier anguleux inclinable (bell crank) (69) dans la rainure du bras de support (49) tandis que la barre d'activation (59) ne touche pas le bras de support (49).

20. Appareil selon une revendication précédente, y compris la revendication 15, caractérisé par le fait que le deuxième élément de support (51) en position de repos est approximativement au ras de la surface du bras de support (49) et en position de fonctionnement dépasse le bras de support (49) d'au moins l'épaisseur de la plaquette.

21. Appareil selon une revendication précédente, y compris la revendication 15, caractérisé par le fait que le deuxième élément de support (51) est d'une forme anguleuse.

22. Appareil selon une revendication précédente, y compris la revendication 15, caractérisé par le fait que le crampon (23) est attaché à une coulisse (21) qui est mobile le long d'un guide linéaire (19) disposé sur le support (17).

23. Appareil selon toutes les revendications 1 à 22 caractérisé par le fait que le crampon (23) peut être déplacé en avant et tourné autour d'un axe (14) orienté perpendiculairement à son axe longitudinal.

24. Procédé pour transporter des objets plats (25), en particulier des substrats, par exemple, des plaquettes, d'une cassette (27) munie de plusieurs sites de chargement à une autre cassette (27) ou d'une cassette à une station de process ou similaire, avec un crampon mobile (23) par lequel, pendant l'action de saisissement, la position du bord avant (45) de l'objet (25) à transporter est déterminée par la direction de faisceaux de lumière essentiellement perpendiculaire au bord (45) de l'objet et détecter la lumière réfléchie par un récepteur (33,33'), et le crampon (23) entre par la suite dans un des espaces à côté du dit objet (25) et dans la cassette (27) jusqu'à ce qu'il puisse saisir l'objet (25) et, après avoir saisi l'objet, le soulever un petit peu et l'ôter de la cassette (27) caractérisé par le fait que le bras de support (49) est muni d'un capteur distance (81, 101) pour mesurer la distance entre le bras de support (49) et au moins un des objets adjacents pour que la position de bras de support (49) ou de la cassette (27) puisse être corrigée automatiquement au moyen d'un procédé de commande/contrôle par boucle de rétroaction de manière à ce que le bras de support (49) ne touche pas l'objet.

25. Méthode selon la revendication 24 caractérisé par le fait que la distance entre le bras de support (49) et les deux objets (25) étant adjacents au bras de support (49) est mesurée continuellement.

26. Méthode selon la revendication 24 ou 25 caractérisé par le fait qu'un élément de support (51) est incliné du plan du bras de support (49) et retracé vers l'objet (25) pour saisir l'objet (25).
